# EUROPEAN PATENT APPLICATION

(11) **EP 4 354 562 A1**
(43) Date of publication of application: **17.04.2024**
(21) Application number: 22820426.9
(22) Date of filing: 13.05.2022
(51) Int. Cl.: H01M 8/1004, H01M 8/0245, H01M 8/0228, H01M 8/0258, H01M 4/88, C23C 14/08, H01M 8/10

(54) **POLYMER ELECTROLYTE MEMBRANE FUEL CELL COMPRISING TUNGSTEN OXIDE-COATED PART AND METHOD FOR MANUFACTURING SAME**

(30) Priority: 10.06.2021 KR 20210075212
(71) Applicant: POSTECH Research and Business Development Foundation, Pohang-si, Gyeongsangbuk-do 37673 (KR)
(72) Inventor: KIM, Yongtae, Busan 48050 (KR); YOU, Sanghoon, Busan 47110 (KR); KANG, Hyesu, Pohang-si Gyeongsangbuk-do 37836 (KR)
(74) Representative: Marks & Clerk LLP
(86) International application number: PCT/KR2022/006868
(87) International publication number: WO 2022/260298

(57) **Abstract**

The present disclosure relates to a polymer electrolyte membrane fuel cell including a tungsten oxide-coated component, where the polymer electrolyte membrane fuel cell includes a unit cell constituted by a membrane-electrode assembly (MEA), in which an electrolyte membrane and a catalyst layer are integrally combined, a gas diffusion layer, and a bipolar plate, and tungsten oxide is coated on a surface of at least one of the membrane-electrode assembly, the gas diffusion layer, or the bipolar plate, and a method for manufacturing the same. According to the present disclosure, catalyst and cell durability can be enhanced by reducing a carbon oxidation reaction through prevention of the occurrence of high voltage under SU/SD conditions, and the performance can be maintained due to the absence of current density reduction even under SU/SD conditions.

## Description

### [Technical Field]

The present invention relates to a polymer electrolyte membrane fuel cell including a tungsten oxide-coated part and a method for manufacturing the same and specifically, the present invention pertains to a polymer electrolyte membrane fuel cell comprising a unit cell with an integrated membrane-electrode assembly (MEA) that combines an electrolyte membrane and a catalyst layer, a gas diffusion layer, and a separator plate, and the present invention is characterized in that the tungsten oxide is coated on the surface of at least one component among the membrane-electrode assembly, gas diffusion layer, or separator plate. The disclosure also covers a method for manufacturing such a fuel cell.

### [Background Art]

During start-up and shut-down situations of a Polymer Electrolyte Membrane Fuel Cell (PEMFC), an abnormal oxygen reduction reaction occurs at an oxidation electrode (anode) due to the presence of residual oxygen. This reaction causes an unusually high voltage, beyond the normal voltage range, to be applied to the cell, which in turn leads to corrosion of the carbon support of the platinum (Pt/C) catalyst in the reduction electrode (cathode) and creates durability issues. Various solutions have been proposed to address these problems. Prior Patent Document 1 provides a fuel cell bipolar plate that is not only thin and lightweight, but also exhibits excellent conductivity and corrosion resistance, as well as a method for manufacturing the same.

Meanwhile, recently, the development of a selective catalyst that prevents oxygen reduction reactions at the oxidation electrode (anode), which can be considered the ultimate cause of problems during start-up/shut-down (SU/SD) conditions, and only promotes the intended hydrogen oxidation reaction, has been attracting significant attention. Among these selective catalysts, a Pt/HₓWO₃₋ₓ catalyst carrying platinum on tungsten oxide has been introduced in an academic journal, garnering interest from the academic community and boasting excellent performance and durability. However, during the commercialization stage of the Pt/HₓWO₃₋ₓ catalyst, the chemical synthesis process that the catalyst must undergo results in relatively random outcomes compared to mechanical processes, leading to unstable quality, specifically in terms of the catalyst's selectivity function. Moreover, using tungsten oxide, a non-conductive material, as a support contributes to the instability in quality and consequently causes issues such as decreased performance and durability of the fuel cells.

Moreover, platinum (Pt/C) catalysts are currently being used for both the anode and cathode in commercial applications. As a result, adopting the new concept of Pt/HₓWO₃₋ₓ catalysts would inevitably lead to significant changes compared to the existing manufacturing processes using platinum (Pt/C) catalysts, and thus the existing processes cannot be utilized, leaving limitations in commercialization and application.

Therefore, there is a need to develop a polymer electrolyte membrane fuel cell that not only increases the selectivity of the catalyst but also has a stable quality capable of enhancing the efficiency and durability of the fuel cell. Furthermore, it is necessary to utilize tungsten oxide materials that can be easily applied to existing manufacturing processes instead of separate processes, resulting in a highly efficient and durable fuel cell, as well as its manufacturing process.

### [Disclosure]

### [Technical Problem]

The present disclosure aims to solve the problems and limitations of the conventional technology as described above.

The objective of the present invention is to provide a polymer electrolyte membrane fuel cell that prevents oxygen reduction reactions at the oxidation electrode (anode), which can be considered the ultimate cause of issues during start-up and/or shut-down (SU/SD) conditions, allows only hydrogen oxidation reactions to occur, maintains fuel cell efficiency, and increases durability by preventing corrosion of the platinum (Pt/C) catalyst, as well as a method for manufacturing the same.

### [Technical Solution]

A polymer electrolyte membrane fuel cell according to the present disclosure may include a unit cell composed of a membrane-electrode assembly (MEA), where an electrolyte membrane and catalyst layer are integrally combined, a gas diffusion layer, and a bipolar plate. Tungsten oxide is coated on the surface of at least one of the membrane-electrode assembly, the gas diffusion layer, or the bipolar plate constituting the unit cell.

In this case, it is preferable for the tungsten oxide to be deposited and coated at a thickness of 450 to 550 nm. This is because if the coated tungsten oxide thickness is less than 450 nm, the amount available for intercalation is insufficient, limiting fuel cell performance improvement, and if the thickness exceeds 550 nm, the non-conductive characteristics of tungsten oxide become dominant, causing a decrease in conductivity.

Meanwhile, the deposition may be performed through physical vapor deposition (PVD) and may also be carried out by sputtering or electron beam vapor deposition.

Furthermore, in the present disclosure, it is more preferable for the tungsten oxide to be coated on the surface of the MEA among the components constituting the polymer electrolyte membrane fuel cell.

Another aspect of the present disclosure is a method for manufacturing a polymer electrolyte membrane fuel cell comprising a tungsten oxide-coated component, the method comprising: forming a membrane-electrode assembly by forming a catalyst layer on each of a front surface and a back surface of a polymer electrolyte membrane; coating the membrane-electrode assembly by depositing tungsten oxide on a surface of the membrane-electrode assembly through physical vapor deposition; coating a gas diffusion layer by depositing tungsten oxide on a surface of the gas diffusion layer through physical vapor deposition; coating a bipolar plate by depositing tungsten oxide on a surface of the bipolar plate through physical vapor deposition; and assembling a unit cell by sequentially stacking the membrane-electrode assembly, the gas diffusion layer, and the bipolar plate, wherein tungsten oxide is coated on a surface of at least one of the membrane-electrode assembly, the gas diffusion layer, or the bipolar plate constituting the unit cell.

In this case, the forming a membrane-electrode assembly may comprise: uniformly applying the tungsten slurry on the surface of an imide film and drying the imide film; and the forming the catalyst layer by attaching to and stacking the catalyst-applied imide film both the front and back surfaces of the polymer electrolyte membrane and applying external pressure and heat to transfer the catalyst to the front and back surfaces of the polymer electrolyte membrane and removing the imide film. may comprise dropping a catalyst slurry on the tungsten oxide layer, uniformly applying the catalyst slurry with a blade, and drying the catalyst slurry.

Furthermore, preferably, the physical vapor deposition performed in the coating the membrane-electrode assembly, the gas diffusion layer or the bipolar plate is one of sputtering or electron beam vapor deposition.

### [Advantageous Effects]

The present invention has advantages in that although a platinum (Pt/C) catalyst, which has been conventionally used, is employed as is in the polymer electrolyte membrane fuel cell, catalyst and cell durability can be ensured by reducing carbon oxidation reactions through the prevention of high voltage occurrence under SU/SD (start-up/shut-down) conditions of the fuel cell. Additionally, performance can be maintained due to the absence of current density reduction even under SU/SD conditions.

Furthermore, the present invention has an additional advantage of being economically simple, in that although the platinum (Pt/C) catalyst, which has been conventionally commercialized and used, is employed as is, performance can be maintained under SU/SD conditions and durability can be improved simply by adding a process of depositing and coating tungsten oxide on the surface of any one of the constituent parts of the fuel cell.

### [Description of Drawings]

FIG 1 shows the overall manufacturing process of a method for manufacturing a polymer electrolyte membrane fuel cell, including a tungsten oxide-coated part according to the present disclosure.
FIG 2 compares surface states before and after depositing and coating tungsten oxide on the surface of each part using sputtering.
FIG 3 is a diagram showing the structure of a polymer electrolyte membrane fuel cell and the deposition position of tungsten oxide.
FIG 4 shows the results of an experiment comparing the performance of a fuel cell, in which tungsten oxide is coated on each of a bipolar plate (BP), a gas diffusion layer (GDL), and a membrane-electrode assembly (MEA) constituting the polymer electrolyte membrane fuel cell, with a fuel cell that uses a conventional platinum (Pt/C) catalyst without coating the constituent parts with tungsten oxide, under SU/SD conditions.
FIG 5 shows the results of an experiment as to whether a high voltage of 1.5 V, which instantaneously causes a carbon oxidation reaction in a cell under SU/SD conditions, is applied through a dynamic hydrogen electrode (DHE) experiment for fuel cells manufactured according to Comparative Examples and Examples.

### [Mode for Invention]

Hereinafter, an exemplary embodiment of the present disclosure will be described in detail with reference to the accompanying drawings.

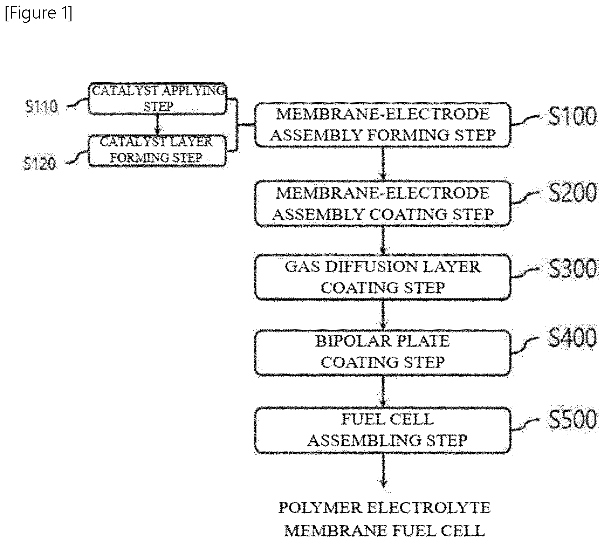

FIG 1 shows an overall manufacturing process of a method for manufacturing a polymer electrolyte membrane fuel cell that includes a tungsten oxide-coated component according to the present disclosure.

The membrane-electrode assembly forming step (S100) is a process of forming a membrane-electrode assembly by forming a catalyst layer on both the front and back surfaces of a polymer electrolyte membrane. Specifically, the membrane-electrode assembly forming step includes a catalyst applying step (S110), where a catalyst slurry is applied to the surface of an imide film and dried, and a catalyst layer forming step (S120), where the catalyst-applied imide film is attached to both the front and back surfaces of the polymer electrolyte membrane, stacked, and then subjected to external pressure and heat to transfer the catalyst to the front and back surfaces of the polymer electrolyte membrane, forming a catalyst layer on each surface, followed by the removal of the imide film.

In this embodiment, platinum (Pt/C) was chosen as the catalyst to form the membrane-electrode assembly (MEA). A 40 wt.% commercial platinum (Pt/C) catalyst was loaded onto the anode at 0.1 mg/cm² and onto the cathode at 0.4 mg/cm² using a decal method. Nafion 211 was used as the material for the polymer electrolyte membrane in the MEA.

The membrane-electrode assembly coating step (S200) involves depositing and coating tungsten oxide onto the surface of the formed MEA using physical vapor deposition (PVD). PVD includes sputtering and electron beam vacuum deposition methods. In this embodiment, tungsten oxide is deposited onto the surface of the MEA to a thickness of, for example, about 500 nm using the sputtering method with a sputter.

The gas diffusion layer coating step (S300) and the bipolar plate coating step (S400) can be performed simultaneously with the MEA coating step (S200) or separately before or after it. In this embodiment, the gas diffusion layer and bipolar plate were placed in the sputter chamber together with the MEA, and tungsten oxide was deposited and coated onto each surface to a thickness of about 500 nm using the sputtering method. The bipolar plate (BP) used in this case was made of graphite material with no surface coating and featured a serpentine-type flow path with a depth and width of 1 mm.

The gas diffusion layer (GDL) was made of a carbon material with a porous structure, and its surface was waterproofed using 20% PTFE.

Then, in the fuel cell assembly step (S500), a polymer electrolyte membrane fuel cell including a unit cell is assembled, where the unicell includes at least one of the MEA, gas diffusion layer, or bipolar plate, each coated with tungsten oxide.

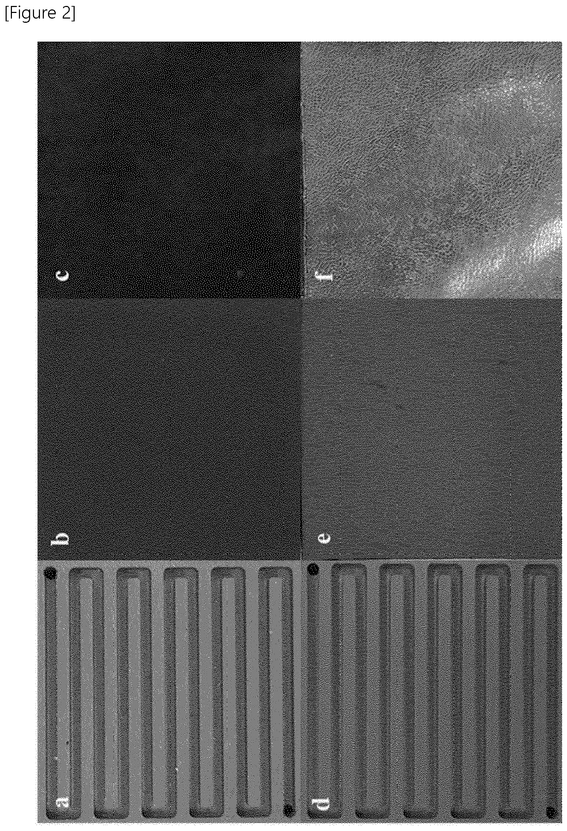

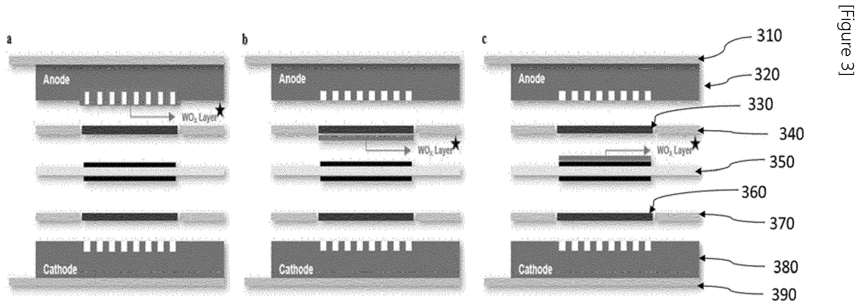

FIG 2 compares surface states before and after depositing and coating tungsten oxide on a surface of each part by sputtering. FIG 3 is a view showing a structure of a polymer electrolyte membrane fuel cell and a deposition position of tungsten oxide.

In FIG 2, the states before and after depositing tungsten oxide on the surface of each component are shown and compared in the upper and lower parts. 'a' and 'd' compare and illustrate the states before and after forming a coating layer by depositing tungsten oxide on the surface of the bipolar plate, 'b' and `e' compare and illustrate the states before and after forming a coating layer by depositing tungsten oxide on the surface of the gas diffusion layer, and 'c' and 'f' compare and illustrate the states before and after forming a coating layer by depositing tungsten oxide on the surface of the membrane-electrode assembly (MEA).

More specifically, a, b, and c in FIG 2 represent the bipolar plate (BP), the gas diffusion layer (GDL), and the membrane-electrode assembly (MEA) before tungsten oxide deposition, respectively, while and d, e, and f in FIG 2 represent the surfaces of the bipolar plate (BP), the gas diffusion layer (GDL), and the membrane-electrode assembly (MEA) after tungsten oxide deposition, respectively.

FIG 3 is a diagram showing the structure of a polymer electrolyte membrane fuel cell and the deposition position of tungsten oxide. Referring to FIG 3, the polymer electrolyte membrane fuel cell includes a first current collector (310), a first bipolar plate (BP, 320) containing an oxidation electrode flow path, a first gas diffusion layer (GDL, 330), a first gasket (340), a membrane-electrode assembly (MEA, 350), a second gas diffusion layer (360), a second gasket (370), a second bipolar plate (380) containing a reduction electrode flow path, and a second current collector. In this case, the first bipolar plate (BP, 320) containing an oxidation electrode flow path, the first gas diffusion layer (GDL, 330), the membrane-electrode assembly (MEA, 350), the second gas diffusion layer (360), and the second bipolar plate (380) containing a reduction electrode flow path are sequentially stacked.

In this case, tungsten oxide can be deposited on the oxidation electrode flow path of the first bipolar plate (320), as shown in FIG 3a. Alternatively, tungsten oxide can be deposited on either the first gas diffusion layer (330) side or the membrane-electrode assembly (MEA) side between the first gas diffusion layer (330) and the membrane-electrode assembly (350), as shown in FIG 3b. In this case, FIG 3a corresponds to d in FIG 2, FIG 3b corresponds to g in FIG 2, and FIG 3c corresponds to f in FIG 2.

When comparing images before and after depositing tungsten oxide on the surface of each component to form a coating layer, it is easy to visually confirm that the color has changed due to the formation of the tungsten oxide layer.

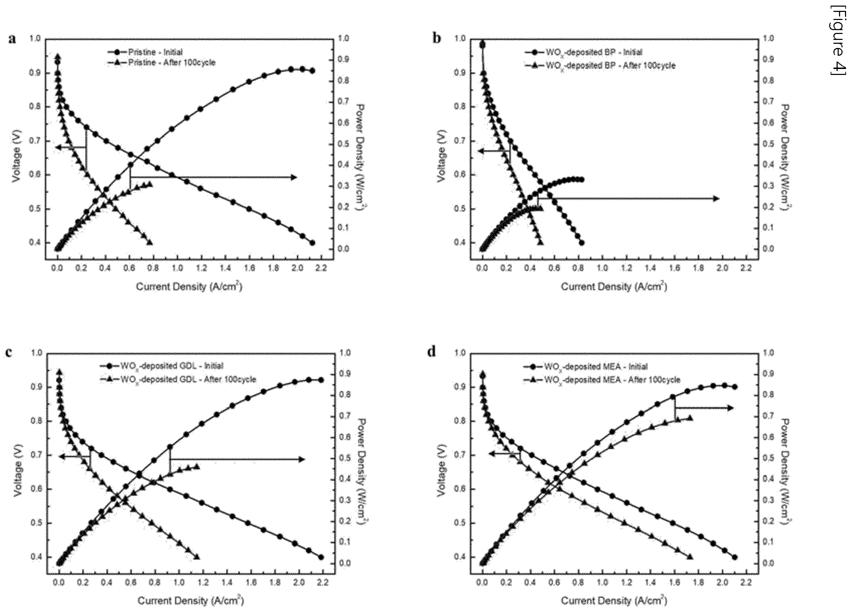

FIG. 4 shows the results of an experiment comparing the performance of fuel cells under SU/SD conditions. One fuel cell has tungsten oxide coated on each of the bipolar plate (BP), gas diffusion layer (GDL), and membrane-electrode assembly (MEA) that include the polymer electrolyte membrane fuel cell, while the other fuel cell uses a conventional platinum (Pt/C) catalyst without coating tungsten oxide on the constituent parts.

A polymer electrolyte membrane fuel cell includes parts without tungsten oxide deposition and coating was constructed with an oxidation electrode (anode), an uncoated graphite bipolar plate, a gas diffusion layer with a PTFE (Poly Tetra Fluoro Ethylene) treated porous carbon surface, a membrane-electrode assembly (MEA) with a platinum (Pt/C) catalyst attached to both the front and back surfaces of the polymer electrolyte membrane, and a reduction electrode (cathode).

Compared to the conventional polymer electrolyte membrane fuel cell (Comparative Example, a), the performances of fuel cells with tungsten oxide deposited and coated to a thickness of 500 nm on the surface of the bipolar plate (Example 1, b), the gas diffusion layer (Example 2, c), and the membrane-electrode assembly (MEA) (Example 3, d) were mutually compared by the current density at about 0.6 V.

In this experiment, the basic performance was measured under conditions of a cell temperature of 70°C and a relative humidity of 100%. The SU/SD protocol test involved evaluating the fuel cell's performance after 100 cycles, where one cycle includes allowing hydrogen to flow through the oxidation electrode and oxygen through the reduction electrode under normal operating conditions, and under SU/SD conditions allowing oxygen to flow through the oxidation electrode until the open circuit voltage (OCV) dropped to 0.2 V

Referring to FIG 4a, in the SU/SD protocol test, the conventional fuel cell using only a platinum catalyst according to the Comparative Example showed a current density of 0.95 A/cm² at the beginning of the test when maintaining 0.6V but decreased to 0.25 A/cm² after 100 cycles. In contrast, FIG 4b shows that for the fuel cell of Example 1 under the same operating conditions, the decrease in current density after 100 cycles was small and the performance of the cell itself did not deteriorate, but the initial performance itself was not high due to a large electrical resistance. According to FIG 4c, the fuel cell of Example 2 showed a small decrease in current density even after 100 cycles, and the performance reduction was less than that of the Comparative Example, but not significantly comparable.

On the other hand, as shown in FIG 4d, when compared with the Comparative Examples and Examples, the fuel cell of Example 3, i.e., the fuel cell with tungsten oxide deposited and coated on the surface of the membrane-electrode assembly (MEA), exhibited almost no decrease in current density even after 100 cycles in the SU/SD protocol test, confirming that no performance degradation occurred.

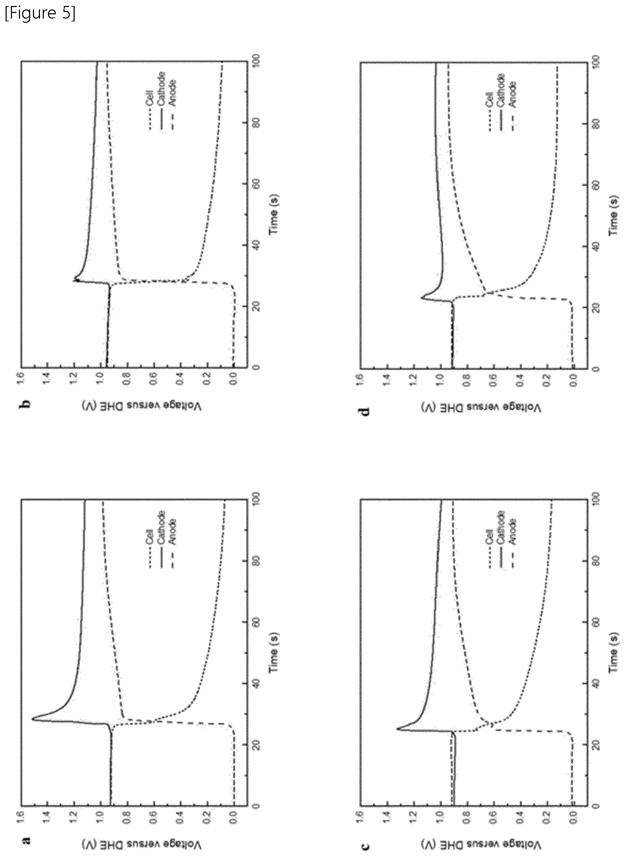

FIG 5 shows the results of an experiment conducted to determine whether a high voltage of 1.5 V, which instantaneously causes a carbon oxidation reaction in a cell under SU/SD conditions, is applied through a Dynamic Hydrogen Electrode (DHE) experiment for fuel cells manufactured according to the Comparative Example and the Examples.

This experiment involves observing the potential profile for 100 seconds. The objective is to determine whether a high voltage of 1.5 V, which triggers a carbon oxidation reaction in the fuel cell when the experiment starts under normal operating conditions and switches to SU/SD conditions after 30 seconds, subsequently degrading the durability of the platinum (Pt/C) catalyst, is generated in the cell.

FIG 5a shows the results of an experiment on a conventional fuel cell using a platinum catalyst manufactured according to the Comparative Example, and FIGs. 5b to 5d show the results of experiments performed under the same conditions and methods on fuel cells manufactured according to Examples 1 to 3, respectively.

Based on the experimental results, it was confirmed that the voltage in the cell rapidly increased up to 1.5 V in the case of the conventional fuel cell according to the Comparative Example, whereas in the case of the fuel cells manufactured according to Examples 1 to 3, the voltage did not rise rapidly up to 1.5 V in the cell itself even when the same experiment was performed.

Therefore, it can be confirmed that in the case of the polymer electrolyte membrane fuel cell according to the present disclosure, even when the condition is suddenly switched from normal operating conditions to SU/SD conditions, the voltage inside the cell does not rapidly increase, preventing the occurrence of carbon oxidation reactions that reduce the durability of the catalyst and maintaining the durability of the fuel cell.

## Claims

1. A polymer electrolyte membrane fuel cell comprising:
a unit cell including a membrane-electrode assembly (MEA) wherein an electrolyte membrane and a catalyst layer are integrally combined;
a gas diffusion layer, and
a bipolar plate,
wherein a tungsten oxide is coated on a surface of at least one of the MEA, the gas diffusion layer, or the bipolar plate constituting the unit cell.

2. The polymer electrolyte membrane fuel cell of claim 1, wherein the tungsten oxide is deposited and coated with a thickness of 450 to 550 nm.

3. The polymer electrolyte membrane fuel cell of claim 2, wherein the deposition is performed by physical vapor deposition.

4. The polymer electrolyte membrane fuel cell of claim 3, wherein the physical vapor deposition is performed by sputtering or electron beam vapor deposition.

5. The polymer electrolyte membrane fuel cell of one of claims 1 to 4, wherein the tungsten oxide is coated on a surface of the MEA.

6. A method for manufacturing a polymer electrolyte membrane fuel cell comprising a tungsten oxide-coated component, the method comprising:
forming a membrane-electrode assembly by forming a catalyst layer on each of a front surface and a back surface of a polymer electrolyte membrane;
coating the membrane-electrode assembly by depositing tungsten oxide on a surface of the membrane-electrode assembly through physical vapor deposition;
coating a gas diffusion layer by depositing tungsten oxide on a surface of the gas diffusion layer through physical vapor deposition;
coating a bipolar plate by depositing tungsten oxide on a surface of the bipolar plate through physical vapor deposition; and
assembling a unit cell by sequentially stacking the membrane-electrode assembly, the gas diffusion layer, and the bipolar plate, wherein tungsten oxide is coated on a surface of at least one of the membrane-electrode assembly, the gas diffusion layer, or the bipolar plate constituting the unit cell.

7. The method of claim 6, wherein the forming of the membrane-electrode assembly comprises:
applying a catalyst by applying a catalyst slurry to a surface of an imide film and drying the imide film;
forming a catalyst layer by attaching and stacking the catalyst-applied imide film to both the front surface and back surface of the polymer electrolyte membrane;
applying pressure and heat from outside to transfer the catalyst to the front surface and back surface of the polymer electrolyte membrane; and
then removing the imide film.

8. The method of claim 6 or 7, wherein the physical vapor deposition is either sputtering or electron beam vapor deposition.
